# EUROPEAN PATENT SPECIFICATION

(11) **EP 3 289 283 B1**
(45) Date of publication and mention of the grant of the patent: **02.11.2022**
(21) Application number: 16787024.5
(22) Date of filing: 27.04.2016
(51) Int. Cl.: F21S 4/26, H01L 25/075, H01L 33/00, H01L 33/50, H01L 33/62, F21Y 103/10, F21Y 115/10, H05B 45/20, H05B 45/24

(54) **FLEXIBLE LED LIGHTING ELEMENT**
FLEXIBLES LED-BELEUCHTUNGSELEMENT
ÉLÉMENT D'ÉCLAIRAGE FLEXIBLE À DEL

(30) Priority: 27.04.2015 US 201514697273; 10.06.2015 US 201562173855 P
(43) Date of publication of application: 07.03.2018
(73) Proprietor: B/E Aerospace, Inc., Wellington, FL 33414 (US)
(72) Inventor: JOHANNESSEN, Eric, Holbrook, NY 11741 (US); TODZIA, Jonathan, Farmingville, NY 11738 (US); LASALA, Donald, Southampton, NY 11968 (US); GAMBESKI, Gannon, T., St. James, NY 11780 (US); DUNN, Matthew, Stony Brook, NY 11790 (US); SAM, Luis, South Setauket, NY 11720 (US)
(74) Representative: Stevens Hewlett & Perkins
(86) International application number: PCT/US2016/029460
(87) International publication number: WO 2016/176266

(56) References cited:
- WO-A1-2013/056012
- US-A1- 2002 001 193
- US-A1- 2005 280 014
- US-A1- 2007 018 181
- US-A1- 2007 018 181
- US-A1- 2009 323 334
- US-A1- 2010 188 778
- US-A1- 2012 013 252
- US-A1- 2012 206 914
- US-A1- 2013 082 984
- US-A1- 2014 367 633
- US-A1- 2015 062 890
- US-A1- 2015 092 429
- US-A1- 2016 053 977
- US-B1- 6 371 637
- US-B1- 6 371 637
- US-B2- 7 893 633

## Description

### BACKGROUND

The present invention relates to a flexible LED lighting element.

US 6371637 discloses a flexible LED array in which a series of LEDs mounted on a flexible PCT substrate are provided within an elongate housing which has a hollow D-shaped profile in cross-section. US 2014/367633 discloses an LED display panel comprising a number of LEDs mounted on a reflective layer with the LED's covered by a wavelength conversion layer which may incorporate phosphor particles. US 2012/206914 discloses a lighting module comprising a number of LEDs mounted on a flexible substrate in a flexible housing.

### SUMMARY

The present invention is defined by a flexible LED lighting element according to claim 1. Further embodiments are defined in the dependent claims. Also disclosed herein, but not defined by the attached claims, is a method for calibrating a flexible LED lighting element comprising at least first-, second-, and third-color LEDs, and white LEDs, as well as an LED unit encapsulant that covers the LEDs and contains embedded phosphor particles of different colors, comprising: a) defining a target color on a color map to calibrate that requires a contribution from at least the first- and second-color LEDs and white LEDs; b) selecting first and second initial calibration coefficients associated with the first- and second-color contributing LEDs that contribute to the target color, and a third initial calibration coefficient that is based on predetermined properties of the LED unit encapsulant and attributes of the white LEDs; c) storing the initial or updated first and second calibration coefficients in a non-volatile memory of the light unit; d) controlling the light unit to simultaneously drive the first and second LEDs to attempt to emit the target color, producing an attempted color, utilizing the first through third calibration coefficients; e) measuring the attempted color to determine if it matches the target color within a predefined tolerance; f) if the attempted color matches the target color, then terminating the method; g) if the attempted color does not match the target color, then performing the following; h) selecting a color component corresponding to the first-color LED; i) updating the first calibration coefficient associated with the selected color component; j) performing (c)-(f) immediately again; k) if the attempted color does not match the target color, then performing the following; l) selecting a color component corresponding to the second-color LED; m) updating the second calibration coefficient associated with the selected color component; n) performing (c)-(f) again.

Also disclosed herein, but not defined by the attached claims, is a method for calibrating a flexible LED lighting element comprising at least first-, second-, and third-color LEDs, and white LEDs, as well as an LED unit encapsulant that covers the LEDs and contains embedded phosphor particles of different colors, comprising: a) defining a target color on a color map to calibrate; b) selecting initial calibration coefficients associated with the target color, wherein one of the initial calibration coefficients is based on predetermined properties of the LED unit encapsulant and attributes of the white LEDs; c) storing: 1) the initial, or 2) updated calibration coefficients in a non-volatile memory of the light unit; d) controlling the light unit with a controller to drive the LEDs to attempt to emit the target color, producing an attempted color, utilizing one of the initial and updated calibration coefficients; e) measuring the attempted color to determine if it matches the target color within a predefined tolerance; f) if the attempted color matches the target color, then terminating the method; g) if the attempted color does not match the target color, then performing the following; h.1) selecting a first color component; i.1) adapting at least one calibration coefficient associated with the selected first color component by a first color component first amount; j.1) performing (c)- (g) again; h.2) selecting a second color component that is different from the first color component; i.2) adapting at least one calibration coefficient associated with the selected second color component by a second color component first amount; j.2) performing (c)-(g) again; h.3) selecting the first color component; i.3) adapting the at least one calibration coefficient associated with the selected first color component by a first color component second amount that is smaller than the first color component first amount and avoids an overshoot of the target color; j.3) performing (c)-(g) again; h.4) selecting the second color component; i.4) adapting the at least one calibration coefficient associated with the selected second color component by a second color component second amount that is smaller than the second color component first amount and avoids an overshoot of the target color; j.4) performing (c)-(g) again; wherein a path in a color space of the attempted colors forms: a) a converging winding path when only two color components are utilized; and b) a converging spiral when three color components are utilized.

### DESCRIPTION OF THE DRAWINGS

Various embodiments of the invention are illustrated in the following drawings, in which:
- Figure 1A and Figure 1B: are a pictorial side view of an embodiment of a flexible LED module assembly;
- Figure 2: is a side view illustrating a bending radius of the module assembly;
- Figure 3: is a cross-sectional view along a longitudinal axis of the module assembly;
- Figure 4A: is a perspective view of the module assembly;
- Figure 4B: is a plan view of the module assembly;
- Figure 4C: is a detail plan view of the module assembly;
- Figure 4D: is a cross-sectional view along the longitudinal axis of the module assembly;
- Figure 4E: is a cross-sectional detail view along the longitudinal axis of the module assembly;
- Figure 5A: is a pictorial side view of a flex LED unit not according to the claimed invention and showing emitted light rays without reflection;
- Figure 5B: is a pictorial side view of the flex LED unit of Figure 5A showing emitted light rays with reflection but with no surrounding encapsulant;
- Figure 5C: is a pictorial side view of a flex LED unit of the invention showing emitted light rays with reflection with surrounding encapsulant having a refractive coefficient similar to that used for the LED unit;
- Figure 6: is a graph that illustrates the impact on the emitted spectrum that the use of the flex encapsulant creates;
- Figure 7: is a CIE chromaticity diagram illustrating the effect of encapsulating the diodes;
- Figure 8A: is a perspective view of a further embodiment of a flexible LED module assembly;
- Figure 8B: is a close-up perspective view of the boxed region in Figure 8A showing a left end of the flexible LED module assembly;
- Figure 8C: is a close-up perspective view showing a right end of the flexible LED module assembly;
- Figure 9: is a perspective view of a diffuser;
- Figure 10: is a cross-sectional view down a longitudinal axis of the embodiment shown in Figure 8A;
- Figure 11A: is a perspective cutaway view illustrating the various components of the embodiment shown in Figure 8A;
- Figure 11B: is a zoomed perspective view of the boxed portion in Figure 11A illustrating the interface of the diffuser; and
- Figure 12: is a plan view of a flexible connector element.

### DETAILED DESCRIPTION

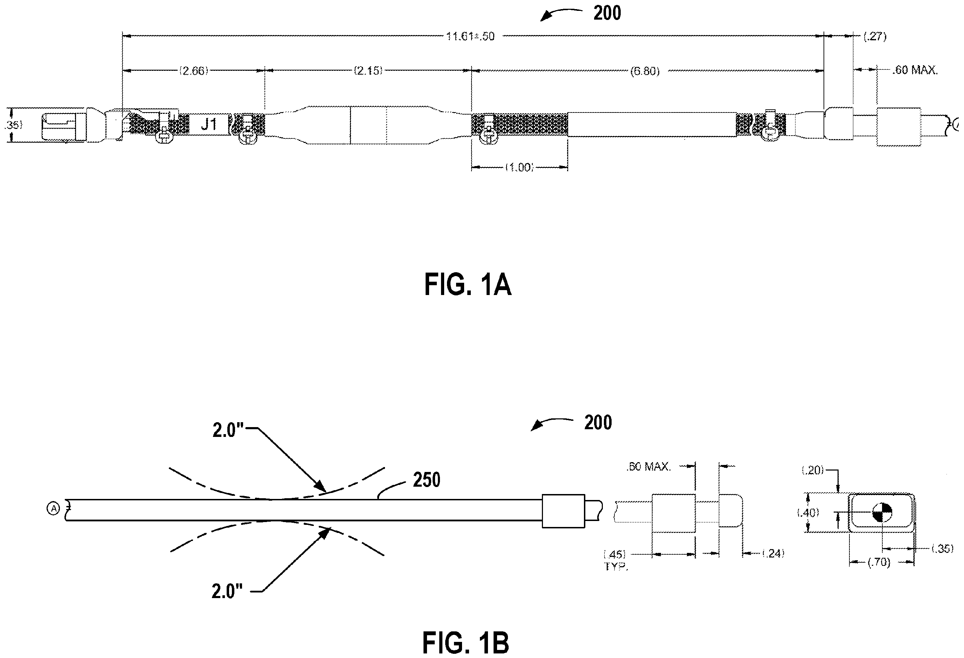

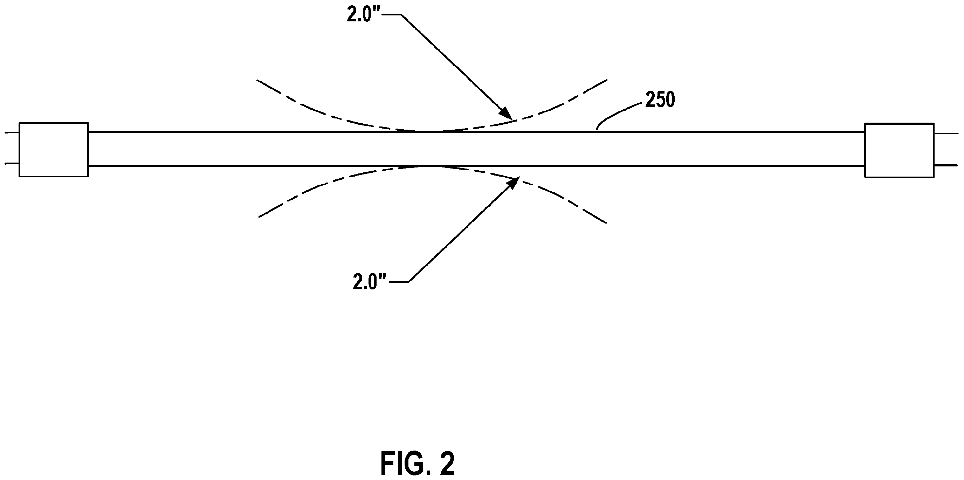

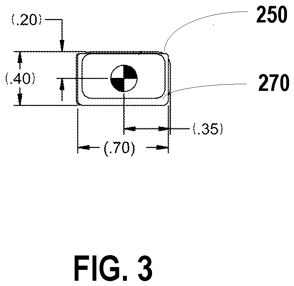

Figure 1A and Figure 1B are a pictorial side view of an embodiment of a flexible (flex) LED module assembly 200. This assembly 200 comprises a flexible LED module 250 along with supporting cables, connectors, and the like. Figure 2 illustrates a bending radius for the LED module 250 as being approximately 5.08 cms (2.0") in a direction along a U-shaped channel of the module 250-in other words, the upper arms of the U are upright and pointing towards the top in Figure 2. The flexible nature of the LED module 250 is due to the use of a flexible PCB with flexible traces on it, combined with a flexible housing 270. Figure 3 is a cross-section of the module 250 and shows the flexible housing 270 along with example dimensions (inches).

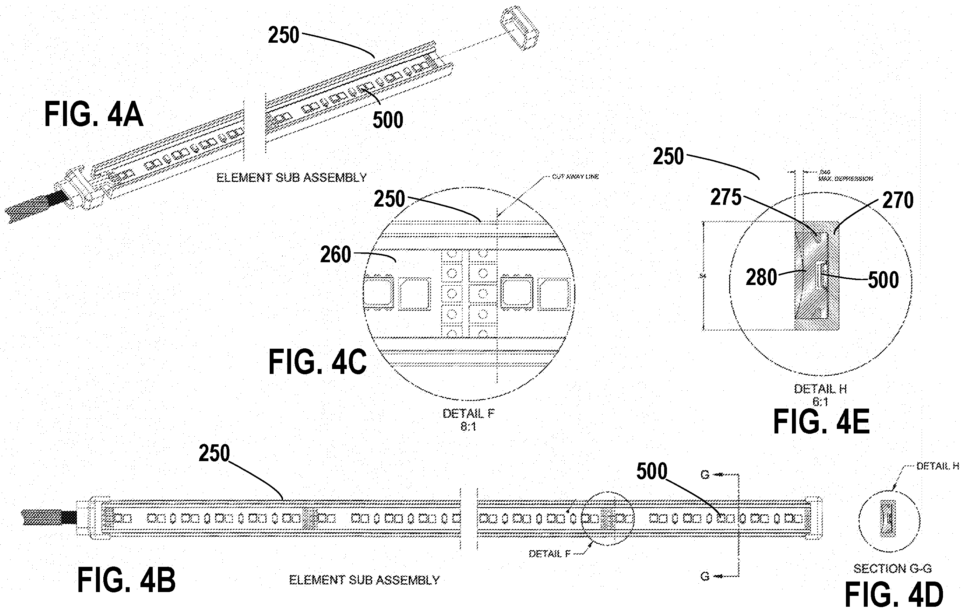

Figure 4A is a perspective view and Figure 4B is a plan view showing in more detail the LED module 250 with a plurality of LED units 500 on them. Figure 4C is a plan detail view showing the circuitry mounted on a flexible PCB 260 of the LED module 250. The LEDs 500 in the module 250 may be densely spaced, e.g., on 1.27 cm (0.5") intervals, in order to maximize the amount of light output.
Figure 4D is a cross-section G-G of the LED module 250 shown in Figure 4B, and Figure 4E is a detail view of this cross-section. The flexible housing 270 is shown in more detail and may or may not comprise protrusions 275 in the side walls that hold in a flexible encapsulant 280 that may be based on, e.g., silicone. The flexible housing 270 is made of a flexible material, such as a known thermally conductive silicone. At a bottom portion of the housing's 270 U-shaped channel is the actual LED 500 itself.

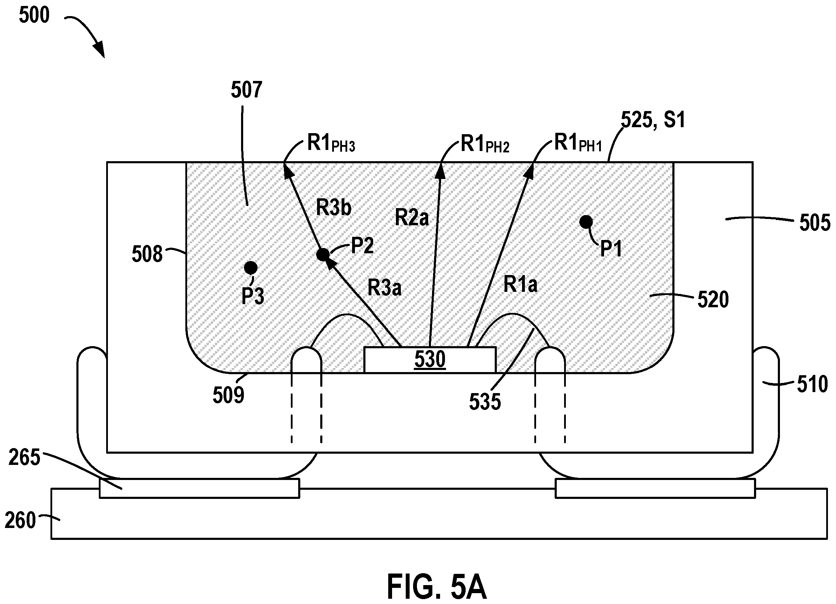

Figure 5A is a more detailed cross-sectional view of Figure 4E, which shows that annealed heavy copper traces 265 may be used in the PCB 260, where this construction provides greater flexibility. In a typical layering for a flexible PCB, there is the laminate layer, then directly above that is a copper foil layer, and then above that is a plated copper layer, and then above that the tin or tin/lead layer. It has been determined that in order to afford the most flexibility, only a single raw annealed heavy copper layer 265 is used above the laminate layer, e.g., a 1220 g/m² (4oz/ft²) (a foil designation of 4, according to Table 1 below), since the addition of plating can cause the copper layer to be more brittle. Although the annealed heavy copper trace it is more costly than the foil layer with copper plating, the flexibility characteristics are greater. This is particularly true when the PCB 260 is coated on both sides, as is done in an embodiment. The use of the heavy single copper layer in combination with the use of extremely efficient LEDs permits a length of the flexible PCB to be as much as 12.2 m (forty feet).

**Table 1**

| *Table of Thicknesses* | | | | | | |
|---|---|---|---|---|---|---|
| Fall Designation | Common Industry Terminology | Metric | | English | | |
| | | Area Weight (g/m²) | Nominal Thickness (µm) | Area Weight (oz./ft) | Area Weight (g/254 in³) | Nominal Thickness (mils) |
| E | 5 µm | 45.1 | 5.1 | 0.148 | 7.4 | 0.20 |
| Q | 9 µm | 75.9 | 8.5 | 0.249 | 12.5 | 0.34 |
| T | 12 µm | 106.8 | 12.0 | 0.350 | 17.5 | 0.47 |
| H | 1/2 αz | 152.5 | 17.1 | 0.500 | 25.0 | 0.68 |
| M | 3/4 αz | 228.8 | 25.7 | 0.750 | 37.5 | 1.01 |
| 1 | 1 αz | 305.0 | 34.3 | 1 | 50.0 | 1.35 |
| 2 | 2 αz | 6100 | 68.6 | 2 | 100.0 | 2.70 |
| 3 | 3 αz | 9150 | 102.9 | 3 | 150.0 | 4.05 |
| 4 | 4 αz | 1220.0 | 137.2 | 4 | 200.0 | 5.40 |
| 5 | 5 αz | 1525.0 | 171.5 | 5 | 250.0 | 6.75 |
| 6 | 6 αz | 1830.0 | 205.7 | 6 | 300.0 | 8.10 |
| 7 | 7 αz | 2135.0 | 240.0 | 7 | 350.0 | 2.45 |
| 10 | 10 αz | 3050.0 | 342.9 | 10 | 600.0 | 13.50 |
| 14 | 14 αz | 4270.0 | 480.1 | 14 | 700.0 | 18.90 |

### IPC Recommended Track Width For 1 oz cooper PCB and 10 °C Temperature Rise

**Table 2**

| *Track Widths* | | |
|---|---|---|
| Current/A | Track Width(mil) | Track Width(mm) |
| 1 | 10 | 0.25 |
| 2 | 30 | 0.76 |
| 3 | 50 | 1.27 |
| 4 | 80 | 2.03 |
| 5 | 110 | 2.79 |
| 6 | 150 | 3.81 |
| 7 | 180 | 4.57 |
| 8 | 220 | 5.59 |
| 9 | 260 | 6.60 |
| 10 | 300 | 7.62 |

One of the problems encountered with the flexible design disclosed herein is that the LED flex modules 250 emit a bluer light than the non-flex counterpart that must be adjusted for. This is due to the flex encapsulant 280 that is introduced into the channel of the housing 270. The reason for this is the following.

Figure 5A shows an LED unit 500 in cross-section. This unit 500 comprises a housing 505 (also U-shaped in cross-section) having a cavity 507. The cavity 507 comprises a wall 508 and floor 509. An LED unit connector 510, which is, e.g., a PCB surface mount connector, is used to mount the LED unit 500 to a PCB of the module 250 and contacts the copper trace 265 of the PCB 260. These unit connectors 510 connect with an LED 530 via internal connectors 535. Within the U-shaped cavity 507 is an encapsulant 520 that holds a number of phosphorous particles P1, P2, P3 having different colors-this is what allows the creation of a white LED unit and an adjustment of the emitted color for the reasons explained below.

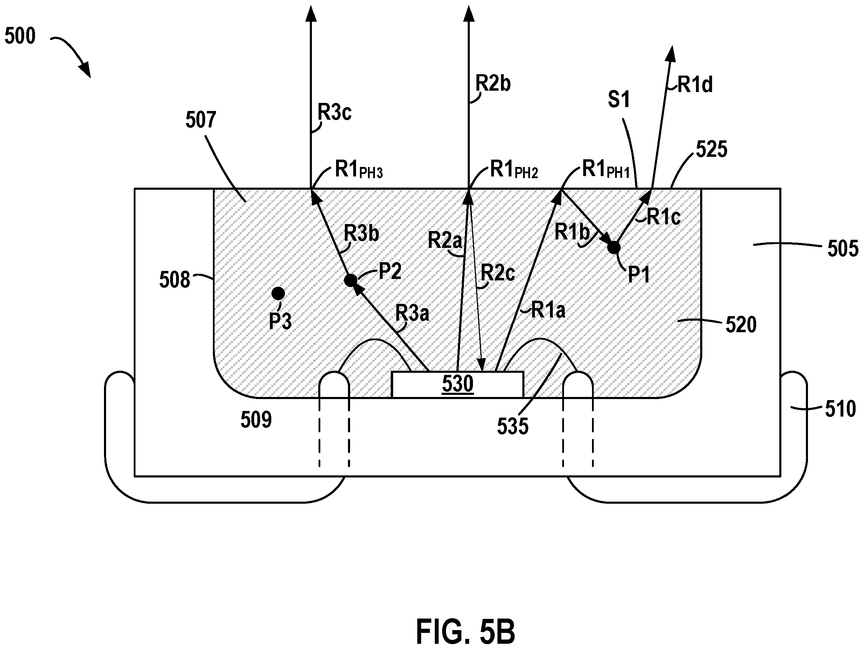

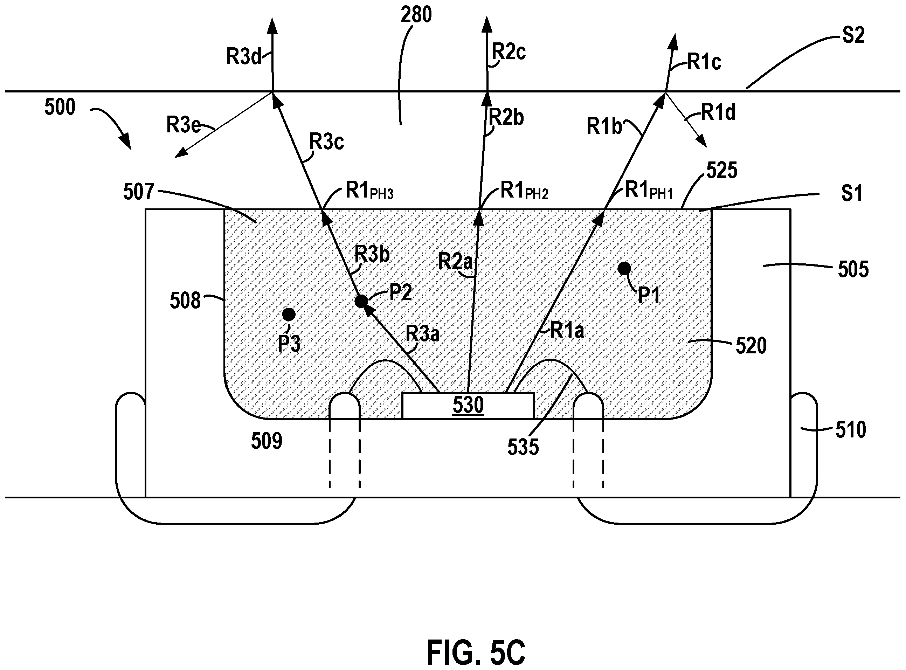

Relatively high-energy blue-colored photons/rays R1a, R2a, R3a are emitted from the LED. In Figure 5A, three colored phosphorous particles P1, P2, and P3 are shown. These particles can include particles that emit blue, red, yellow, and orange colored light and are distributed throughout the LED encapsulant 520. In Figure 5A, only one of the light rays (R3a) interacts with one of the particles (P2). When the high energy ray R3a interacts with the particle P2, a lower energy colored ray R3b is emitted, and the emission can be in any random direction since this is due to an energy state change-the difference in energy is known as the Stokes' shift. Figure 5A only shows the rays en route to the surface (S1) 525 of the LED unit 500. Figure 5B illustrates what happens to the rays after contact with the surface 525 without the flex encapsulant 280, and Figure 5C illustrates what happens to the rays after contact with the surface S1 with the flex encapsulant 280.

In Figure 5B, when originating light ray R1a hits the surface 525, it is completely reflected back into the LED encapsulant 520 in a light ray R1b, which strikes a phosphorous particle P1 and emits a different colored ray R1c which then exits the LED unit as another ray R1d, Thus, the original ray R1a which would have had the bluish color of the LED were it not for the reflection at the surface 525, now has, e.g., a red color, due to the reflection from the surface 525. The originating Ray R3a, as described above with respect to Figure 5A is not changed, since it has already directly interacted with the particle P2, and exits the LED unit in a ray R3c, which is, e.g., green in color.

Figure 5C illustrates the situation in which the flex encapsulant 280 is present. Since the flex encapsulant 280 is made of the same or similar flexible material (e.g., silicone) (absent the phosphorous particles, although, in an embodiment, phosphorous particles may also be included in the flex encapsulant 280) as the LED encapsulant 520, non-interacting original LED light rays (e.g., R1a) that would have reflected back into the phosphorous embedded LED encapsulant 520 and gotten a second chance to interact with a particle (e.g., P1) are instead directed out of the LED unit (R1b), since the index of refraction of the two materials (flex encapsulant 280 and LED encapsulant 520) is the same. Since rays that would have been reflected but are not due to the presence of the flex encapsulant 280 now exit the LED module 250 at the surface S2, the emitted light takes on a bluer color, which must be accounted for.

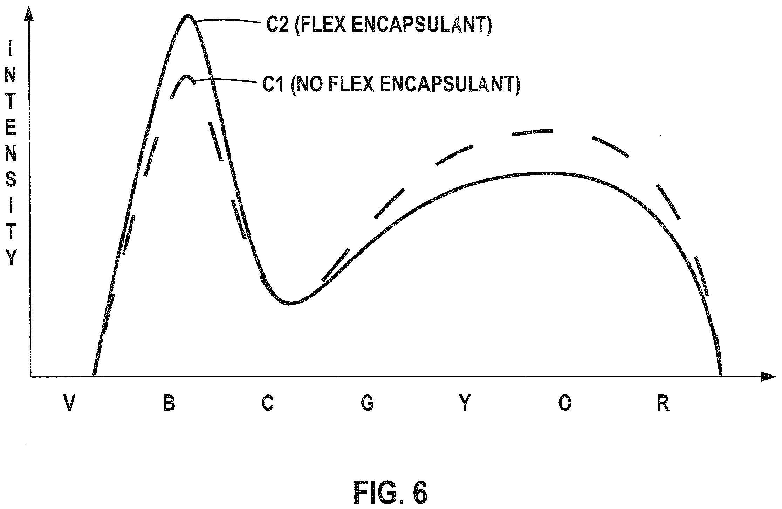

Figure 6 is a graph that illustrates the impact on the emitted spectrum that use of the flex encapsulant 280 creates, with C1 being the intensity v. frequency curve when there is no flex encapsulant 280, and C2 being the curve when the flex encapsulant 280 is present.

Calibration procedures, such as those disclosed in U.S. Patent Publication No. 2012 0013252, may be utilized in calibrating the LED module 250. However, in order to properly calibrate the flex LED module 250, the color shift caused by the flex encapsulant 280 must be taken into account-for a warm white LED, the color shift may be, e.g., 900 °K, whereas for a cool white LED, the color shift may be 1200 °K.

Thus, an adjustment factor must be included into the calibration process. The adjustment factor and calibration process can also compensate for LED intensity changes, color of the PCB mask (e.g., a white solder mask), a color shift from thermal effects, and varying flex encapsulant 280 thickness.

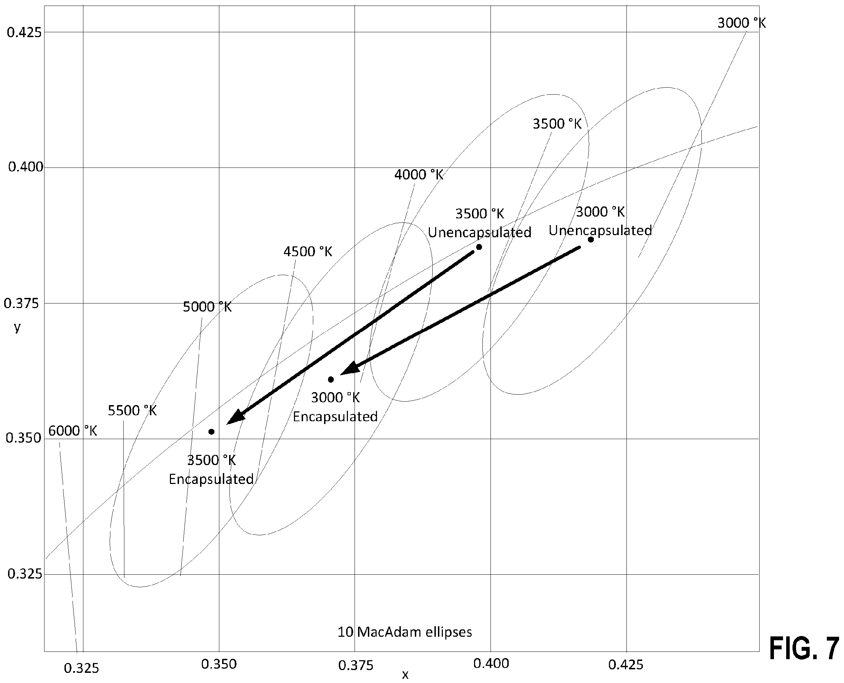

Figure 7 is a graph of a portion of a CIE chromaticity diagram illustrating the color shifts created by use of the encapsulant for both 3000 °K and 3500 °K LEDs. As can be seen, the use of the encapsulant shifts, in both instances, the color towards a more blue (hotter) color temperature. The following table provides example data upon which the Figure 7 graph is based. The LED shift vs. its initial condition of the color temperature is non-linear, meaning that the shift is greater for cooler LEDs, and thus, this non-linear aspect should be taken into consideration in determining the adjustment factor.

**Table 3**

| *Color Shifts for Encapsulated vs. Unencapsulated LEDs* | | | | | |
|---|---|---|---|---|---|
| | **3500K LED** | | | **3000K LED** | |
| | **Unencapsulated** | | **Encapsulated** | **Unencapsulated** | **Encapsulated** |
| **x** | 0.398 | | 0.3485 | 0.4185 | 0.3705 |
| **y** | 0.3852 | | 0.3512 | 0.3866 | 0.3609 |
| **CCT** | 3620K | | 4869K | 3182K | 4172K |
| **Shift Magnitude** | | 0.0601 | | 0.0544 | |
| **Shift Angle** | | -34 | | -28 | |

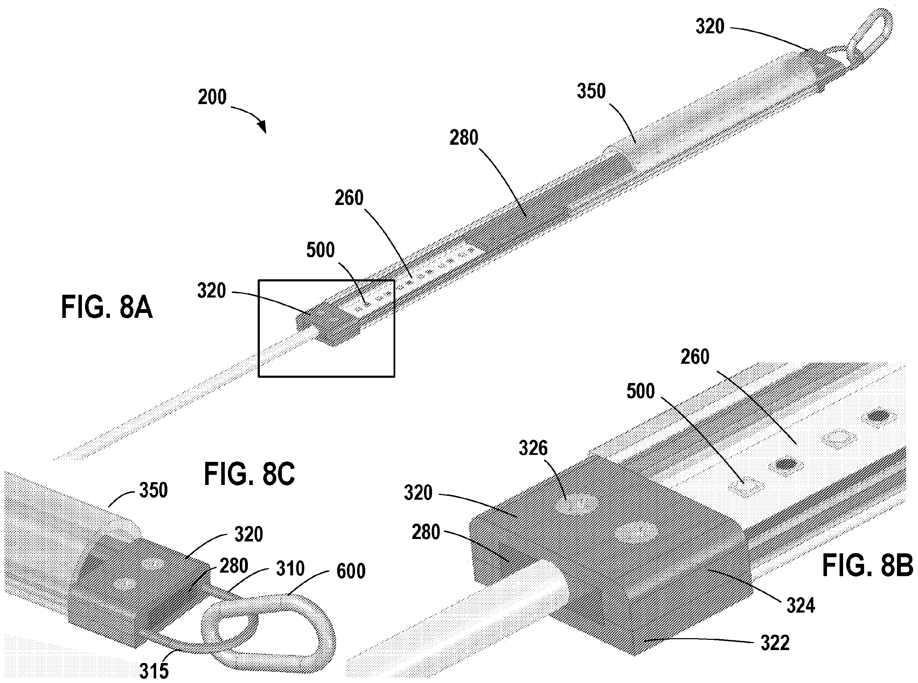

Figure 8A is a perspective view of a further embodiment of a flexible LED module assembly 200. This embodiment illustrates a particular form of end caps 320 and diffuser 350. These features are illustrated in more detail in Figures 8B and 8C. In Figure 8B, the end cap 320 has a bottom 322 and top 324 portion that are held together with fasteners 326 such as screws. These fasteners 326 also serve to fix the flex LED module 250 and flexible PCB 260 to the end cap 320 as well. An electrical cable (not numbered) enters the end cap 320 on one side, and is surrounded by a flex encapsulant 280 which may be the same flex encapsulant 280 that fills the assembly 200, or it could be comprised of a different material that has at least one of a flexible property and a sealing property. In Figure 8C, the end cap 320 can be seen with two reinforcing rods 310 (discussed in more detail below) protruding from the end with a connection loop 315 joining the reinforcing rods, forming a loop through which, e.g., a lanyard 600 may be extended for fixing the assembly 200 to a particular location.

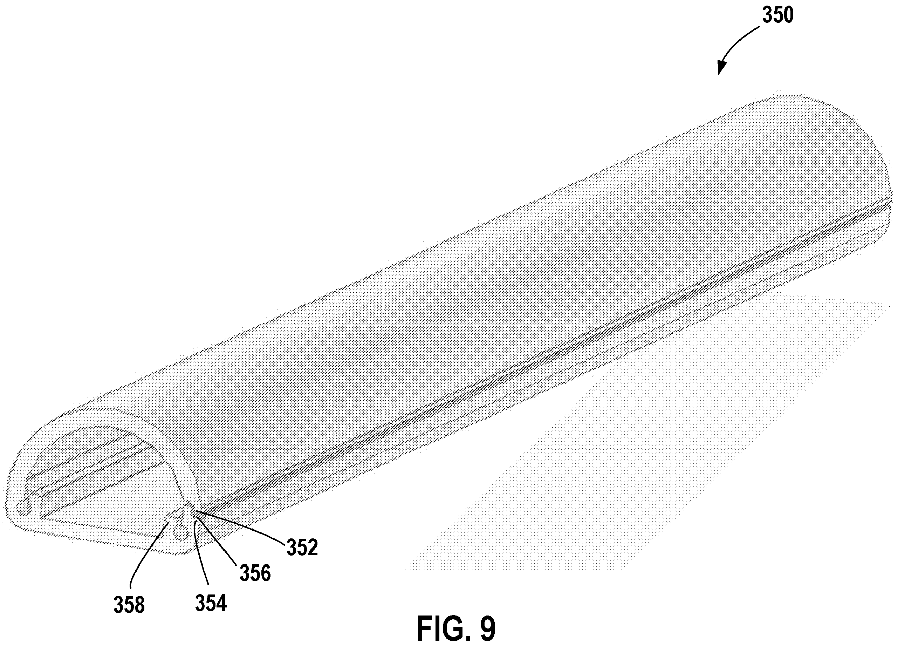

Figure 9 is a perspective view of a diffuser 350 that can be utilized to provide an even light and prevent hot spots by suitably locating a top portion of the diffuser 350 away from LEDs 500 of the unit. The diffuser may be constructed with a gap 356 on one side formed by a meeting of a top edge 352 and bottom edge 354 on one side of the diffuser 350. The diffuser may have an inner protrusion 358 that forms a portion of a wall for holding the reinforcing rod.

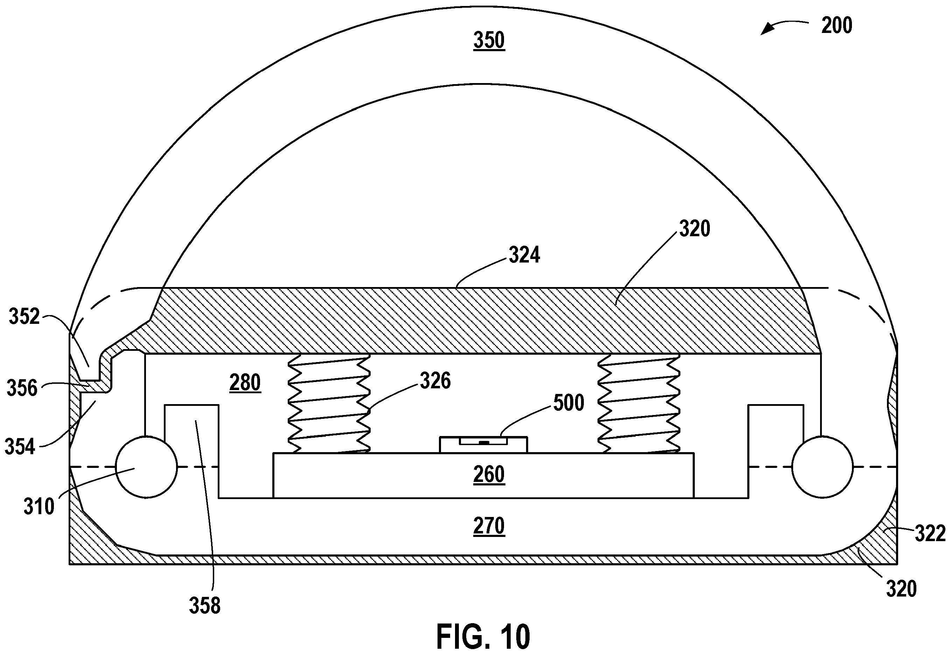

Figure 10 is a cross-sectional view of the embodiment shown in Figure 8A, and shows the relationship between portions of the end cap 320 with respect to the diffuser 350 and the flexible PCB 260 with LED 500 mounted on it. As can be seen in Figure 10, the main cavity of the unit is filled with the flex encapsulant 280. Also shown are the reinforcing rods 310. These rods 310 extend longitudinally down the length of the LED module assembly 200. In an embodiment, these rods 310 are made of a conductive metal that, in addition to providing a strengthening reinforcement, may provide grounding and possibly heat sinking functions. They also help protect the flexible PCB 260 from damage, since the reinforcing rods 310 would absorb most of the bending or tensile forces in the unit 200. Metallic rods 310 can be made of steel if strength properties are most important, copper if conductive properties are most important, or any other metal that has desirable characteristics. The rods can provide a ground for high voltage AC applications for additional safety and for electrostatic discharge (ESD) protection.

However, other materials can be used, and these materials may have similar characteristics to metal, or can have different characteristics. For example, for cost and other reasons (stress characteristics, etc.), nylon rods 310 could be used. However, the conductive nature of the rods 310 is lost when the material is nylon or other non-conducting material. Referring back to Figure 8C, the rods 310 may be extended from the end cap, and a connecting loop 315 can join the two. When the rods 310 are made of a conductive material, this loop 315 can then serve to better ground the unit by linking these together. When the loop 315 is non-conductive, it can at least serve as a convenient mechanism for fastening.

Also, although a circular cross-section shape is shown, any cross sectional shape including rectangular, oblong, etc. may be used. Also, as can be seen in the cross sectional view, the top of the inner protrusions 358 are higher than, and the rod 310 is higher than or level with the PCB 260 and LED 500, thus providing additional shielding/protection, particularly cut protection. The rod 310 also allows the unit 200 to form naturally inherent catenary curves when bending corners and permits it to span gaps without structural reinforcements.

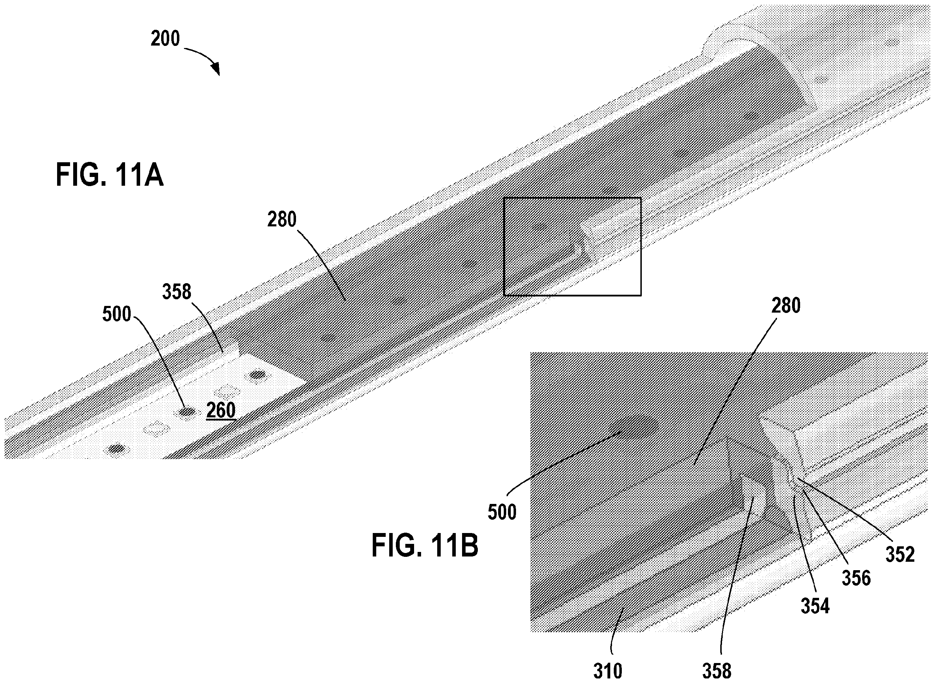

Figures 11A and 11B are perspective cut-away views of the assembly 200. The interface can be seen particularly well in Figure 11B where the gap 356 formed by the top 352 and bottom 354 edges is shown in relation to the flex encapsulant 280, and the construction of the diffuser 350 holding in the rods 310. The gap 356 permits the encapsulate 280 to be added by spreading the diffuser 350 open at the gap. The diffuser material, which is resilient, can then reform back into its relatively closed (optionally, but not necessarily, sealed) configuration.

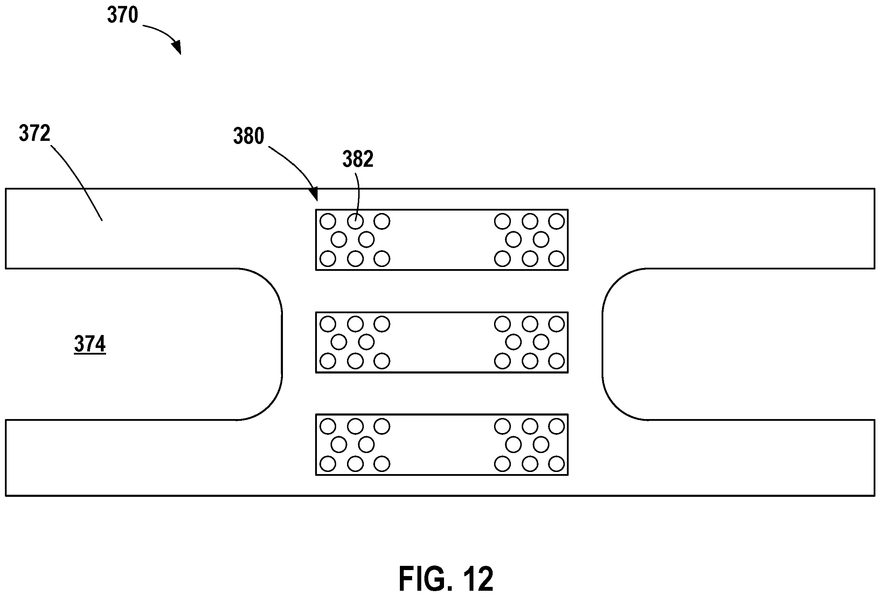

Figure 12 is a plan view of a flexible connector 370 that can be used to join together two or more assemblies 200. The connector 370 is flat and relatively thin, and may be made out of metal, plastic, nylon, or any material that provides flexibility while maintaining some supportive strength that allows two connected units to bend to some degree. On each end, the connector 370 has a pair of legs 372 having in between them a U-shaped cutout region 374. The central portion constitutes an electrical connection region 380. In Figure 12, the electrical connection region is broken down into three sub-regions (not labeled), which each constitute holes for inserting wires or a plug or pin connections. The legs 372 may be designed protrude into a bottom part of the diffuser 350 or into bottom portions of the flex module 250 itself.

The unit may further comprise a ground fault circuit interrupt (GFCI) as well as surge suppression. The GFCI may be implemented as a small front end PCB module that supports multiple lengths of lighting units 200. Additionally, surge/spike and ESD protection can be provided, possible on the same PCB or front end module. A separate power factor correction (PFC) and/or harmonic filter can be provided as well.

The system or systems described herein may be implemented on any form of computer or computers and the components may be implemented as dedicated applications or in client-server architectures, including a web-based architecture, and can include functional programs, codes, and code segments. Any of the computers may comprise a processor, a memory for storing program data and executing it, a permanent storage such as a disk drive, a communications port for handling communications with external devices, and user interface devices, including a display, keyboard, mouse, etc. When software modules are involved, these software modules may be stored as program instructions or computer readable codes executable on the processor on a computer-readable media such as read-only memory (ROM), random-access memory (RAM), CD-ROMs, magnetic tapes, floppy disks, and optical data storage devices. The computer readable recording medium can also be distributed over network coupled computer systems so that the computer readable code is stored and executed in a distributed fashion. This media is readable by the computer, stored in the memory, and executed by the processor.

For the purposes of promoting an understanding of the principles of the invention, reference has been made to the preferred embodiments illustrated in the drawings, and specific language has been used to describe these embodiments. However, no limitation of the scope of the invention is intended by this specific language, and the invention should be construed to encompass all embodiments that would normally occur to one of ordinary skill in the art as set out in the attached claims.

The embodiments herein may be described in terms of functional block components and various processing steps. Such functional blocks may be realized by any number of hardware and/or software components that perform the specified functions. For example, the described embodiments may employ various integrated circuit components, e.g., memory elements, processing elements, logic elements, look-up tables, and the like, which may carry out a variety of functions under the control of one or more microprocessors or other control devices. Similarly, where the elements of the described embodiments are implemented using software programming or software elements the invention may be implemented with any programming or scripting language such as C, C++, Java, assembler, or the like, with the various algorithms being implemented with any combination of data structures, objects, processes, routines or other programming elements. Functional aspects may be implemented in algorithms that execute on one or more processors. Furthermore, the embodiments of the invention could employ any number of conventional techniques for electronics configuration, signal processing and/or control, data processing and the like. The words "mechanism" and "element" are used broadly and are not limited to mechanical or physical embodiments, but can include software routines in conjunction with processors, etc.

The particular implementations shown and described herein are illustrative examples of the invention and are not intended to otherwise limit the scope of the invention in any way. For the sake of brevity, conventional electronics, control systems, software development and other functional aspects of the systems (and components of the individual operating components of the systems) may not be described in detail. Furthermore, the connecting lines, or connectors shown in the various figures presented are intended to represent exemplary functional relationships and/or physical or logical couplings between the various elements. It should be noted that many alternative or additional functional relationships, physical connections or logical connections may be present in a practical device. Moreover, no item or component is essential to the practice of the invention unless the element is specifically described as "essential" or "critical".

The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings. Expressions such as "at least one of," when preceding a list of elements, modify the entire list of elements and do not modify the individual elements of the list.

The use of the terms "a" and "an" and "the" and similar referents in the context of describing the invention (especially in the context of the following claims) should be construed to cover both the singular and the plural. Furthermore, recitation of ranges of values herein are merely intended to serve as a shorthand method of referring individually to each separate value falling within the range, unless otherwise indicated herein, and each separate value is incorporated into the specification as if it were individually recited herein. Finally, the steps of all methods described herein are performable in any suitable order unless otherwise indicated herein or otherwise clearly contradicted by context. The use of any and all examples, or exemplary language (e.g., "such as") provided herein, is intended merely to better illuminate the invention and does not pose a limitation on the scope of the invention unless otherwise claimed.

**Table of Reference Characters**

| | |
|---|---|
| 200 | flex LED module assembly |
| 250 | flex LED module |
| 260 | flexible PCB |
| 265 | flexible PCB traces |
| 270 | flex LED module housing |
| 275 | flexible housing protrusions |
| 280 | flex encapsulant |
| 310 | reinforcing rod |
| 315 | connecting loop |
| 320 | end cap |
| 322 | end cap bottom |
| 324 | end cap top |
| 326 | fastener / screw |
| 328 | terminating silicone |
| 350 | diffuser |
| 352 | top edge |
| 354 | bottom edge |
| 356 | gap |
| 358 | inner protrusion |
| 370 | flexible connector |
| 372 | leg |
| 374 | U-shaped cutout |
| 380 | electrical connection region |
| 382 | holes |
| 500 | LED unit |
| 505 | housing |
| 507 | housing cavity |
| 508 | housing cavity wall |
| 509 | housing cavity floor |
| 510 | LED unit connector |
| 520 | LED unit encapsulant |
| 525 | LED unit top surface (see also S1) |
| 530 | LED |
| 535 | LED internal connector |
| 600 | lanyard |
| Px | phosphorous particles |
| Rx | light rays |
| S1 | LED unit top surface (see also 525) |
| S2 | flex encapsulant surface |

## Claims

1. A flexible LED lighting element, comprising:
a flexible U-shaped housing (270) having a bottom and side walls, so as to define a channel;
a flexible printed circuit board (260) mounted in the channel on the bottom wall and
comprising:
an LED unit (500), comprising:
a unit U-shaped housing (505) having a cavity (507);
an LED (530) mounted to a bottom surface of the unit U-shaped housing (505); and
an LED unit connector (510) configured to mount the LED unit (500) to the flexible printed circuit board (260); and
the flexible printed circuit board (260) further comprising a flexible PCB trace (265)
to which the LED unit connector (510) is connected, the trace (265)
comprising a single copper layer;
**characterised in that** the LED unit (500) further comprises an LED unit encapsulant (520) that:
is configured to cover the LED (530);
is comprised within the cavity (507) so as to fill the unit U-shaped housing (505); and
contains embedded phosphor particles of different colors;
wherein the flexible LED lighting element further comprises a flexible encapsulant (280) provided in the channel of the flexible U-shaped housing (270, wherein the flexible encapsulant (280) is configured to fill the channel of the flexible U-shaped housing (270), to thereby cover the unit U-shaped housing (505), wherein an index of refraction of the flexible encapsulant (280) is the same as an index of refraction of the LED unit encapsulant (520).

2. The flexible LED lighting element according to claim 1, wherein the flexible LED lighting element is configured to be bendable to a 5.08 cm radius about an axis that is parallel to the side walls of the flexible U-shaped housing (270).

3. The flexible LED lighting element according to claim 2, wherein:
the flexible U-shaped housing (270):
is made from flexible silicone;
has cross-sectional rectangular dimensions of approximately 1.78 cm wide and 1.02 cm high, the thickness of the bottom and side walls being approximately 1.27 mm; and
the flexible PCB trace (265) is approximately 0.14 mm thick.

4. The flexible LED lighting element according to any one of claims 1 to 3 and further comprising:
a flexible diffuser (350) having a top arched portion which is located above the flexible U-shaped housing (270) and away from the LED (530).

5. The flexible LED lighting element according to claim 4, wherein the flexible diffuser (350) has a single edge opening in the form of a gap (356) formed by a meeting of a top edge (352) and a bottom edge (354) on one side of the flexible diffuser (350).

6. The flexible LED lighting element according to claim 4, further comprising a stiffening rod (310), wherein the flexible diffuser (350) comprises an inner protrusion (358) that forms a portion of a wall for holding the stiffening rod (310) such that the stiffening rod (310) extends longitudinally through the flexible LED lighting element.

## Patentansprüche

1. Flexibles LED-Beleuchtungselement, umfassend:
ein flexibles U-förmiges Gehäuse (270) mit einem Boden und Seitenwänden, sodass ein Kanal definiert ist;
eine flexible Leiterplatte (260), die an der Bodenwand in dem Kanal angebracht ist und umfasst:
eine LED-Einheit (500), umfassend:
ein U-förmiges Einheitsgehäuse (505) mit einem Hohlraum (507);
eine LED (530), die an einer Bodenfläche des U-förmigen Einheitsgehäuses (505) angebracht ist; und
einen LED-Einheitsverbinder (510), der konfiguriert ist, die LED-Einheit (500) an der flexiblen Leiterplatte (260) anzubringen; und
wobei die flexible Leiterplatte (260) ferner eine flexible Leiterplattenbahn (265) umfasst, mit welcher der LED-Einheitsverbinder (510) verbunden ist, und die Bahn (265) eine einzelne Kupferschicht umfasst;
**dadurch gekennzeichnet, dass** die LED-Einheit (500) ferner ein LED-Einheitsvergussmaterial (520) umfasst, das:
konfiguriert ist, die LED (530) abzudecken;
innerhalb des Hohlraums (507) enthalten ist, sodass es das U-förmige Einheitsgehäuse (505) füllt; und eingebettete Phosphorpartikel verschiedener Farben enthält;
wobei das flexible LED-Beleuchtungselement ferner ein flexibles Vergussmaterial (280) umfasst, das in dem Kanal des flexiblen U-förmigen Gehäuses (270) vorgesehen ist, wobei das flexible Vergussmaterial (280) konfiguriert ist, den Kanal des flexiblen U-förmigen Gehäuses (270) zu füllen, um dadurch das U-förmige Einheitsgehäuse (505) abzudecken, wobei ein Brechungsindex des flexiblen Vergussmaterials (280) der gleiche ist wie ein Brechungsindex des LED-Einheitsvergussmaterials (520).

2. Flexibles LED-Beleuchtungselement nach Anspruch 1, wobei das flexible LED-Beleuchtungselement derart konfiguriert ist, dass es bis zu einem Radius von 5,08 cm um eine Achse biegbar ist, die parallel zu den Seitenwänden des flexiblen U-förmigen Gehäuses (270) verläuft.

3. Flexibles LED-Beleuchtungselement nach Anspruch 2, wobei:
das flexible U-förmige Gehäuse (270):
aus flexiblem Silikon hergestellt ist;
rechteckige Querschnittsabmessungen von ungefähr 1,78 cm Breite und 1,02 cm Höhe aufweist und die Dicke der Bodenwand und der Seitenwände ungefähr 1,27 mm beträgt; und
die flexible Leiterplattenbahn (265) ungefähr 0,14 mm dick ist.

4. Flexibles LED-Beleuchtungselement nach einem der Ansprüche 1 bis 3, ferner umfassend:
einen flexiblen Diffusor (350) mit einem oberen gewölbten Abschnitt, der sich oberhalb des flexiblen U-förmigen Gehäuses (270) und von der LED (530) entfernt befindet.

5. Flexibles LED-Beleuchtungselement nach Anspruch 4, wobei der flexible Diffusor (350) eine einzelne Kantenöffnung in der Form eines Spalts (356) aufweist, der durch ein Zusammentreffen einer oberen Kante (352) und einer unteren Kante (354) auf einer Seite des flexiblen Diffusors (350) gebildet ist.

6. Flexibles LED-Beleuchtungselement nach Anspruch 4, ferner umfassend einen Versteifungsstab (310), wobei der flexible Diffusor (350) einen inneren Vorsprung (358) umfasst, der einen Abschnitt einer Wand zum Halten des Versteifungsstabs (310) bildet, sodass sich der Versteifungsstab (310) in Längsrichtung durch das flexible LED-Beleuchtungselement erstreckt.

## Revendications

1. Elément d'éclairage à DEL flexible, comprenant :
un boîtier flexible en forme de U (270) comportant un fond et des parois latérales, de manière à définir un canal ;
une carte de circuit imprimé flexible (260) montée dans le canal sur la paroi inférieure et comprenant :
une unité de DEL (500), comprenant :
un logement unitaire en forme de U (505) comportant une cavité (507) ;
une DEL (530) montée sur une surface inférieure du boîtier unitaire en forme de U (505) ; et
un connecteur d'unité de DEL (510) configuré pour monter l'unité de DEL (500) sur la carte de circuit imprimé flexible (260) ; et
la carte de circuit imprimé flexible (260) comprenant en outre une piste PCB flexible (265) à laquelle le connecteur d'unité DEL (510) est connecté, la piste (265) comprenant une seule couche de cuivre ;
**caractérisé en ce que** l'unité de DEL (500) comprend en outre un encapsulant d'unité de DEL (520) qui :
est configuré pour couvrir la DEL (530) ;
est compris à l'intérieur de la cavité (507) de manière à remplir le boîtier unitaire en forme de U (505) ; et
contient des particules de phosphore incrustées de différentes couleurs ;
dans lequel l'élément d'éclairage à DEL flexible comprend en outre un encapsulant flexible (280) prévu dans le canal du boîtier flexible en forme de U (270),
dans lequel l'encapsulant flexible (280) est configuré pour remplir le canal du boîtier flexible en forme de U (270), pour couvrir ainsi le boîtier unitaire en forme de U (505), dans lequel un indice de réfraction de l'encapsulant flexible (280) est le même qu'un indice de réfraction de l'encapsulant de l'unité de DEL (520).

2. Elément d'éclairage à DEL flexible selon la revendication 1, dans lequel l'élément d'éclairage à DEL flexible est configuré pour être pliable à un rayon de 5,08 cm autour d'un axe qui est parallèle aux parois latérales du boîtier flexible en forme de U (270) .

3. Elément d'éclairage à DEL flexible selon la revendication 2, dans lequel :
le boîtier flexible en forme de U (270) :
est fabriqué à partir de silicone souple ;
a des dimensions rectangulaires en coupe transversale d'environ 1,78 cm de largeur et 1,02 cm de hauteur, l'épaisseur des parois inférieure et latérale étant d'environ 1,27 mm ; et
la piste PCB flexible (265) a une épaisseur d'environ 0,14 mm.

4. Elément d'éclairage DEL flexible selon une quelconque des revendications 1 à 3 et comprenant en outre :
un diffuseur flexible (350) ayant une partie arquée supérieure qui est située au-dessus du boîtier flexible en forme de U (270) et à distance de la DEL (530).

5. Elément d'éclairage flexible à DEL selon la revendication 4, dans lequel le diffuseur flexible (350) possède un seul bord s'ouvrant sous la forme d'un espace (356) formé par une rencontre d'un bord supérieur (352) et d'un bord inférieur (354) d'un côté du diffuseur flexible (350).

6. Elément d'éclairage DEL flexible selon la revendication 4, comprenant en outre une tige de renforcement (310), dans lequel le diffuseur flexible (350) comprend une protubérance intérieure (358) qui forme une partie d'une paroi pour maintenir la tige de renforcement (310) de sorte que la tige de renforcement (310) s'étende longitudinalement à travers l'élément d'éclairage à DEL flexible.
